# EUROPEAN PATENT APPLICATION

(11) **EP 4 814 527 A1**
(43) Date of publication of application: **30.09.2026**
(21) Application number: 26167183.8
(22) Date of filing: 24.03.2026
(51) Int. Cl.: G01R 33/561, G01R 33/54, G01R 33/565, G01R 33/563

(54) **MAGNETIC RESONANCE IMAGING APPARATUS AND CONTROL METHOD THEREOF**

(30) Priority: 28.03.2025 JP 2025056864
(71) Applicant: FUJIFILM Corporation, Tokyo 106-8620 (JP)
(72) Inventor: SHIRAI, Toru, Tokyo, 106-8620 (JP); HAMADA, Munesato, Tokyo, 106-8620 (JP); IGARASHI, Yoshikatsu, Tokyo, 106-8620 (JP); KUNUGI, Yoshiyuki, Tokyo, 106-8620 (JP); SATO, Yoshitaka, Tokyo, 106-8620 (JP); UEDA, Taisei, Tokyo, 106-8620 (JP)
(74) Representative: Dehns Germany Partnerschaft mbB

(57) **Abstract**

Provided is a technique of suppressing an extension of an imaging time and performing high-accuracy N/2 ghost correction in imaging in which a signal is collected by EPI.

A one-shot pre-scan in which a blip-shaped phase-encoding gradient magnetic field is executed alternately in an EPI sequence is performed to generate N/2 ghost-free data having different polarities, and pseudo N/2 ghost data is created from the N/2 ghost-free data. A correction kernel based on a signal of a measurement point to be corrected and signals of measurement points on an even line and an odd line around the measurement point is calculated using the pseudo N/2 ghost data. The main scan data is corrected using the correction kernel with respect to the signals of the measurement point to be corrected and the measurement points on the even line and the odd line around the measurement point.

## Description

### CROSS-REFERENCE TO RELATED APPLICATIONS

The present application claims priority under 35 U.S.C. § 119 to Japanese Patent Application No. 2025-056864, filed March 28, 2025. Each of the above application(s) is hereby expressly incorporated by reference, in its entirety, into the present application.

### BACKGROUND OF THE INVENTION

### 1. Field of the Invention

The present invention relates to a magnetic resonance imaging apparatus (hereinafter, referred to as an MRI apparatus), and particularly to a technique of reducing an artifact specific to a pulse sequence in a case of performing imaging using a pulse sequence based on an echo planar imaging (EPI) method.

### 2. Description of the Related Art

The MRI apparatus performs imaging by controlling an intensity of an applied gradient magnetic field, an application timing of the gradient magnetic field, a collection timing of a nuclear magnetic resonance signal, and the like according to a predetermined pulse sequence in a case of collecting the nuclear magnetic resonance signal from a subject. Various pulse sequences are known, and the EPI is a method of inverting a polarity of a readout gradient magnetic field at high speed after one excitation and generating and collecting a large number of nuclear magnetic resonance signals as gradient echoes for each inversion, and is used for various imaging as a high-speed imaging pulse sequence. For example, in diffusion-weighted imaging (DWI) of imaging a tissue having a property of diffusing, such as blood or cerebrospinal fluid, by applying a plurality of large-amplitude gradient magnetic fields (MPG pulses), it is necessary to perform imaging a plurality of times by varying a magnitude or an application axis of the MPG pulse, and the imaging is easily affected by body motion. Therefore, an EPI sequence that is an ultra-high-speed imaging sequence capable of scanning the entire k-space by acquiring one signal (one-shot) is used as an imaging sequence.

However, in the EPI, due to B0 inhomogeneity generated in a readout direction (x direction), an output delay of a gradient magnetic field power supply that drives a gradient magnetic field coil, and an influence of a gradient magnetic field pulse rise and fall or an eddy current caused by the output delay, a deviation of an applied area of the readout gradient magnetic field occurs between a case where the polarity of the readout gradient magnetic field is positive and a case where the polarity of the readout gradient magnetic field is negative, and a scanning trajectory (k trajectory) changes in a case where an echo signal collected in a case where the polarity of the readout gradient magnetic field is positive and a case where an echo signal collected in a case where the polarity of the readout gradient magnetic field is negative are arranged in the k-space. That is, a deviation of an echo peak occurs in the k-space between the echo arranged on an odd line of the k-space and the echo arranged on an even line of the k-space. The deviation between the odd and even lines on the k-space appears as an N/2 ghost (also referred to as a Nyquist ghost) in a real space (image space).

The above-described DWI is repeated a plurality of times using the EPI, and a plurality of images (k-space) obtained by the repetition are processed to provide an image effective for diagnosis of a microcerebral hemorrhage, a cerebral infarction, or the like, and the DWI is used for calculation of a diffusion coefficient or the like. Therefore, the influence of the artifact generated by the EPI is extremely large, and it is essential to eliminate the artifact in order to perform imaging with high accuracy.

Various methods have been proposed for eliminating the artifact generated by the EPI. For example, Bruder H, Fischer H, Reinfelder HE, Schmitt F. Image reconstruction for echo planar imaging with nonequidistant k-space sampling. Magn Reson Med 1992;23:311-323. discloses a method of correcting a scan (hereinafter, referred to as a main scan) for acquiring an image of an imaging target using one-shot reference data acquired without applying a blip-shaped phase-encoding gradient magnetic field. In the present method, a phase difference between the odd and even lines is obtained on an x-ky space, the phase difference is linearly approximated, and the phase difference between the odd and even lines of the main scan data is corrected on the x-ky space using the phase difference of the linearly approximated reference data. However, the method has a problem in that it cannot cope with a high-order phase change generated in the readout direction, and has a problem in that a phase change between the odd and even lines in the phase encoding direction in a case where the blip-shaped phase-encoding gradient magnetic field is added cannot be corrected.

On the other hand, US11002815B and US10557907B propose a method (2D correction) that can cope with the high-order phase change and the phase difference generated in the two-dimensional direction of the k-space. For example, in the method described in US11002815B, in addition to even echo data and odd echo data of the main scan, third data (pre-scan data) in which the N/2 ghost is not generated is acquired, relationship information between the third data and each even echo and each odd echo is estimated using the third data, the k-space data of the even echo and the k-space data of the odd echo are corrected based on the relationship information, and the corrected data are combined. In the method described in US10557907B, a convolution kernel is calculated based on measurement data of the main scan without using the pre-scan data as in the method described in US11002815B. The convolution kernel is applied to the measurement data to generate synthetic data, and combined data is generated based on the synthetic data and the measurement data.

These methods can correct the high-order phase, and particularly, the method described in US10557907B does not have a problem in that the imaging time is extended because there is no pre-scan. However, all of these methods have a problem in that the correction accuracy is reduced as the acceleration rate is increased in the parallel imaging method.

On the other hand, W. Scott Hogel* and Jonathan R. Polimeni. Dual-Polarity GRAPPA for Simultaneous Reconstruction and Ghost Correction of Echo Planar Imaging Data. Magn Reson Med 2016;76:32-44 discloses a technique of executing a two-shot pre-scan in which the blip-shaped phase-encoding gradient magnetic field is applied to invert the polarity of the readout gradient magnetic field (inverting a method of inverting the positive and negative), generating data without the N/2 ghost, data having only a positive polarity, and data having only a negative polarity from the two-shot reference data, calculating a correction kernel for correcting the N/2 ghost and a kernel for interpolating an undersampling point based on the three types of data, and performing interpolation of the undersampling point at the same time as the correction of the odd and even lines.

This technique can perform the parallel imaging processing while eliminating the N/2 ghost caused by the high-order phase, and does not have the problems as in the two above-described patent documents. However, there is a problem in that the two-shot pre-scan is required to acquire the reference data, the imaging time is unavoidably extended, and the N/2 remains in a case where there is body motion or the like between the two pre-scans.

### SUMMARY OF THE INVENTION

As described above, the 1D correction has a problem in that the high-order phase difference between the odd and even lines cannot be eliminated, and the 2D correction can solve the high-order phase difference, but has problems in that the correction accuracy is reduced at a high acceleration rate, the imaging time is extended, and is affected by body motion.

An object of the present invention is to provide an MRI technique that can solve the high-order phase difference, can maintain the correction accuracy even in high-speed imaging at a high acceleration rate, and can minimize the extension of the imaging time and can eliminate the influence of the body motion as much as possible.

In order to solve the above-described problems, the present invention performs a one-shot pre-scan in which the application of the blip-shaped phase-encoding gradient magnetic field is controlled alternately, and generates pseudo data without the N/2 ghost using the data of the pre-scan. A correction kernel is calculated using the pseudo data and odd line data and even line data of the reference data, and the correction kernel is applied to the main scan data.

That is, the MRI apparatus according to the present invention includes: an imaging unit that measures a nuclear magnetic resonance signal generated from an examination target according to a predetermined pulse sequence; and a processor that performs an operation including image reconstruction using the nuclear magnetic resonance signal and controls an operation of the imaging unit, in which the processor is configured to: execute a pulse sequence based on an echo planar imaging method of applying, after one excitation RF pulse application, a readout gradient magnetic field, which has an application polarity that vibrates between positive and negative, and a blip-shaped phase-encoding gradient magnetic field, and measuring an echo signal and collecting k-space data each time the polarity of the applied readout gradient magnetic field is inverted, as a main scan; and execute a pre-scan sequence based on an echo planar imaging method of changing the application of the blip-shaped phase-encoding gradient magnetic field in the main scan such that the application is performed once per two inversions of the polarity of the readout gradient magnetic field, as a pre-scan. In addition, the processor is configured to: divide reference k-space data collected in the pre-scan into first reference data consisting of a positive-polarity signal obtained in a case where the application polarity of the readout gradient magnetic field is positive and second reference data consisting of a negative-polarity signal obtained in a case where the application polarity of the readout gradient magnetic field is negative; generate at least two pieces of pseudo N/2 ghost data in which the positive-polarity signal and the negative-polarity signal are alternately arranged, using the first reference data and the second reference data; calculate a correction kernel for correcting N/2 ghost using the pseudo N/2 ghost data; and correct, using the correction kernel, the main scan k-space data collected by executing the main scan, and perform image reconstruction using the corrected k-space data.

In addition, a control method of an MRI apparatus according to the present invention is a control method of an MRI apparatus including an imaging unit that measures a nuclear magnetic resonance signal generated from an examination target according to a predetermined pulse sequence, and an operation unit that performs an operation including image reconstruction using the nuclear magnetic resonance signal, the control method including: controlling the imaging unit to execute a main scan sequence based on an echo planar imaging method of applying, after one excitation RF pulse application, a readout gradient magnetic field, which has an application polarity that vibrates between positive and negative, and a blip-shaped phase-encoding gradient magnetic field, and measuring an echo signal and collecting k-space data each time the polarity of the applied readout gradient magnetic field is inverted, and a pre-scan sequence based on an echo planar imaging method of changing the application of the blip-shaped phase-encoding gradient magnetic field in the main scan such that the application is performed once per two inversions of the polarity of the readout gradient magnetic field. In addition, the control method includes: controlling the operation unit to divide reference k-space data collected in a pre-scan into first reference data consisting of a first echo signal (positive-polarity signal) obtained in a case where the application polarity of the readout gradient magnetic field is positive and second reference data consisting of a second echo signal (negative-polarity signal) obtained in a case where the application polarity of the readout gradient magnetic field is negative; generating at least two pieces of pseudo N/2 ghost data in which the positive-polarity signal and the negative-polarity signal are alternately arranged, using the first reference data and the second reference data; calculating a correction kernel using the pseudo N/2 ghost data; and correcting, using the correction kernel, the main scan k-space data collected by executing the main scan, and performing image reconstruction using the corrected k-space data.

According to the present invention, an extension of the imaging time can be reduced by using only one-shot EPI data as the reference data in order to calculate the correction kernel for correcting the main scan data obtained by the EPI. In addition, since the correction kernel is created using the pseudo N/2 ghost data created from the reference data, and the correction kernel is applied to the signal of the correction target point and the signals on the odd line and the even line around the point (a plurality of signals including the positive-polarity signal and the negative-polarity signal) to perform the correction, the processing of correcting each odd line and each even line and then combining the corrected data can be eliminated, and the processing can be simplified. In addition, since the correction includes the signal of the correction target point itself, the correction with high accuracy can be performed.

### BRIEF DESCRIPTION OF THE DRAWINGS

FIG. 1 is a diagram showing an overall outline of an MRI apparatus.
FIG. 2 is a functional block diagram of a processor.
FIG. 3 is a diagram showing a flow of processing of Embodiment 1.
FIG. 4 is a diagram showing a flow of N/2 ghost correction processing.
FIG. 5 is a diagram showing a DWI sequence as an example of the main scan.
FIG. 6 is a diagram showing an encoding portion of the main scan and k-space data obtained by the main scan.
FIG. 7 is a diagram showing an encoding portion of the pre-scan and k-space data obtained by the pre-scan.
FIG. 8 is a diagram showing generation of pseudo N/2 ghost data.
FIG. 9 is a diagram showing calculation of a correction kernel using the pseudo N/2 ghost data.
FIG. 10 is a diagram showing correction of main scan k-space data using the correction kernel.
FIG. 11 is a diagram showing various aspects of the correction kernel.
FIG. 12 is a diagram showing a flow of processing of Embodiment 2.
FIG. 13 is a diagram showing an example of a first pre-scan used in Embodiment 2.
FIG. 14 is a diagram showing a flow of 1D correction.
FIG. 15 is a diagram showing an effect of correction of Embodiment 1 performed at an acceleration rate = 1.
FIG. 16 is a diagram showing an effect of correction of Embodiment 1 performed at an acceleration rate = 2.
FIG. 17 is a diagram showing an effect of correction of Embodiment 2.

### DESCRIPTION OF THE PREFERRED EMBODIMENTS

Hereinafter, embodiments of the present invention will be described with reference to the accompanying drawings.

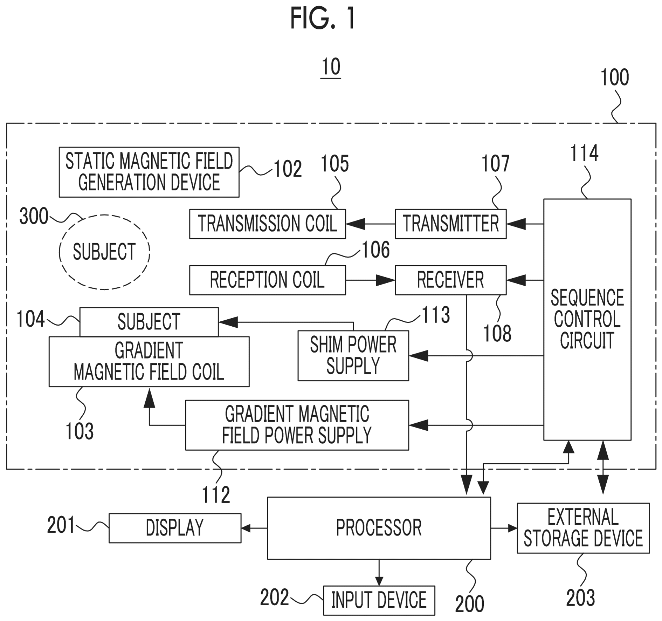

First, an embodiment of an MRI apparatus to which the present invention is applied will be described with reference to FIG. 1. The MRI apparatus 10 comprises, broadly, an imaging unit 100 and a processor 200. A configuration of the imaging unit 100 is the same as that of a known MRI apparatus, and detailed description thereof will be omitted. However, the imaging unit 100 comprises a static magnetic field generation device 102 that generates a uniform magnetic field in an imaging space on which a subject 300 is placed, a gradient magnetic field coil 103 that applies a gradient magnetic field to the static magnetic field, a shim coil 104 that corrects the uniformity of the static magnetic field, a transmission coil 105 that applies a high-frequency magnetic field to cause a nuclear magnetic resonance phenomenon in atoms (atomic nuclei) of a tissue constituting the subject 300, and a reception coil 106 that detects a nuclear magnetic resonance signal generated from the subject 300.

The transmission coil 105 is connected to a transmitter 107 comprising a high-frequency oscillator, a high-frequency amplifier, or the like, and the reception coil 106 is connected to a receiver 108 comprising a quadrature detection circuit, an A/D converter, or the like. In a case where the reception coil 106 is a multi-channel reception coil, the reception coil 106 is connected to each of the receivers 108 for each channel. The gradient magnetic field coil 103 and the shim coil 104 are connected to a gradient magnetic field power supply 112 and a shim power supply 113, respectively.

The imaging unit 100 further comprises the transmitter 107, the receiver 108, the gradient magnetic field power supply 112, and the shim power supply 113 that are connected, and a sequence control circuit 114 that controls the operation of these units. The sequence control circuit 114 operates each unit of the imaging unit 100 according to a predetermined pulse sequence. As a result, the imaging unit 100 performs imaging. It should be noted that various types of pulse sequences are stored in a storage device or the like described below, and for example, a user selects a predetermined pulse sequence according to the purpose or the target of the imaging and sets imaging parameters such as an echo time (TE), a repetition time (TR), the number of slices, and a FOV, so that a pulse sequence used for actual imaging is determined. The selection of the pulse sequence and the setting of the imaging parameters are not always performed by the user each time, and may be determined in advance as an examination protocol, or may be set or changed under the control of the processor described below.

The processor 200 has a function of performing operations such as image reconstruction using the nuclear magnetic resonance signal collected by the imaging unit 100 and correction processing, and a function of controlling the operation of the entire apparatus including the imaging unit 100, and devices such as a display 201, an input device 202, and an external storage device 203 are connected. In addition, although not shown, the processor 200 can be connected to an external database, an off-device processor, or the like through a network such as the Internet or an in-facility network.

Although the processor 200 is shown as one block in FIG. 1, the processor 200 may be configured by one or a plurality of pieces of hardware or a combination of hardware and a program. For example, the processor 200 may be composed of hardware such as a central processing unit (CPU), a micro processing unit (MPU), a programmable logic device such as a field programmable gate array (FPGA), a dedicated circuit for executing specific processing, such as an application specific integrated circuit (ASIC), a graphics processing unit (GPU), or a neural processing unit (NPU). Further, the type of hardware may be a combination of different types of hardware. In a case in which the plurality of types of hardware are configured to execute one or a plurality of types of processing of a certain processor, the plurality of types of hardware may exist in devices physically separated from each other or may exist in the same device.

In a case where the processor 200 is implemented by a combination of hardware and a program, the program may be software such as firmware or microcode. In addition, the program may be, for example, a program module group, and each function thereof may be realized by a processor configured to execute each function. The program may be a program code or a plurality of code segments stored in one or a plurality of non-transitory computer-readable media (for example, a storage medium and other storages).

The MRI apparatus according to the present embodiment comprises, as functions of the processor 200, a function (control of imaging unit) of executing a one-shot pre-scan using an EPI pulse sequence (hereinafter, simply referred to as an EPI sequence) that is the same as the EPI sequence for the main scan but has a different application form of the blip-shaped phase-encoding gradient magnetic field, in a case where the imaging unit 100 executes the EPI sequence, in addition to the main scan for collecting data used for image reconstruction of the subject 300, and a function (main scan data correction function) of creating data (pseudo N/2 ghost data, hereinafter, also simply referred to as pseudo data) including a pseudo N/2 ghost using data (reference data) obtained by the pre-scan, calculating a correction kernel for correcting the main scan data based on the pseudo data, and correcting the main scan data using the correction kernel.

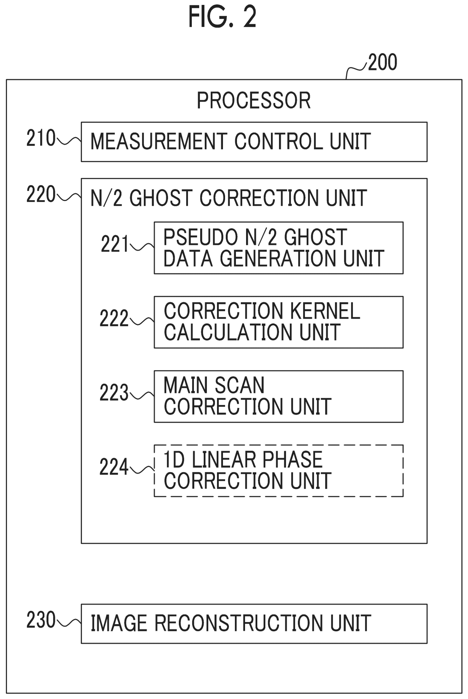

FIG. 2 is a functional block diagram of the processor 200 that implements these functions. As shown in FIG. 2, the processor 200 comprises a measurement control unit 210, an N/2 ghost correction unit 220, and an image reconstruction unit 230. The N/2 ghost correction unit 220 comprises a pseudo N/2 ghost data generation unit 221, a correction kernel calculation unit 222, and a main scan correction unit 223. It should be noted that the N/2 ghost correction unit 220 may comprise a function of correcting the N/2 ghost or the like by a method other than a correction method using the correction kernel, and FIG. 2 shows, as an example, a correction unit (1D linear phase correction unit 224) that performs 1D correction. However, this is not essential.

Although not shown in FIG. 2, the processor 200 may further comprise functions such as a display control function of controlling the display 201 and a user interface function of communicating with the input device 202 or an external device.

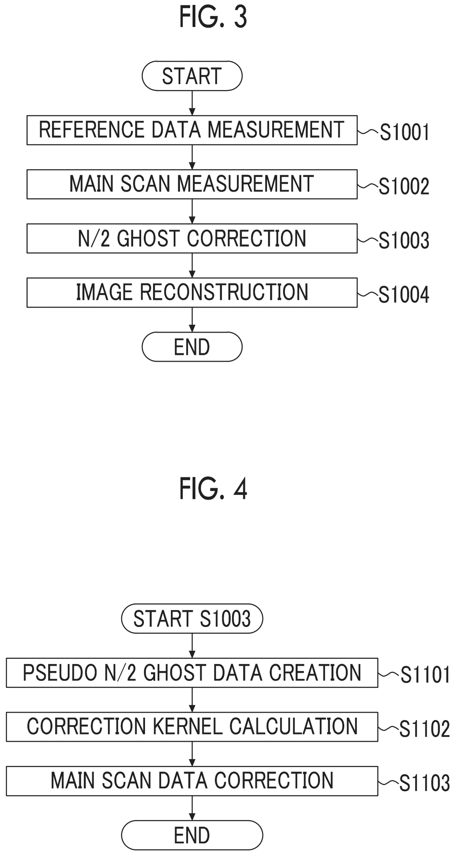

Next, an outline of an operation of the MRI apparatus according to the present embodiment will be described based on the above-described configuration. FIGS. 3 and 4 show a flow of the operation. As shown in FIG. 3, under the control of the processor 200, the imaging unit 100 first executes the one-shot pre-scan to collect the reference data (S1001). Next, the main scan including the EPI sequence is executed to collect the main scan data (S1002). The pre-scan includes the same one-shot EPI sequence as the main scan, but is different from the main scan in that the blip-shaped phase-encoding gradient magnetic field is applied alternately in the EPI sequence.

The processor 200 corrects the N/2 ghost using the collected reference data (S1003), and performs the image reconstruction using the corrected main scan data (S1004). In the correction of the N/2 ghost, as shown in FIG. 4, the processor 200 executes the creation of the pseudo N/2 ghost data using the reference data (S1101), the calculation of the correction kernel (S1102), and the correction of the main scan data (S1103).

In the creation of the pseudo N/2 ghost data (S1101), the reference data is divided into two pieces of N/2 ghost-free data (first reference data and second reference data) having different polarities, and the pseudo N/2 ghost data is created from the N/2 ghost-free data. In addition, the calculation of the correction kernel (S1102) is performed based on the signals of the measurement point to be corrected and the signals of the measurement points on the even line and the odd line around the measurement point, using the two pieces of pseudo N/2 ghost data. The correction of the main scan data (S1103) is performed by applying the correction kernel to the main scan data with respect to a plurality of signals including the positive-polarity signal and the negative-polarity signal corresponding to the correction kernel, that is, the signals of the measurement point to be corrected and the signals of the measurement points on the even line and the odd line around the measurement point, and performing a convolution operation.

According to the MRI apparatus of the present embodiment, since the correction kernel is calculated by creating the N/2 ghost-free positive-polarity data, negative-polarity data, and pseudo N/2 ghost data for correction from the reference data obtained by the one-shot pre-scan, the extension of the imaging time for obtaining the reference data can be suppressed. In addition, since the correction kernel based on the plurality of positive-polarity signals and negative-polarity signals including the signal to be corrected is created from these three pieces of data, the subsequent processing such as combining is not required, unlike in a case of performing the correction for each of the positive polarity and the negative polarity, and the correction with high accuracy can be performed. Furthermore, since the processing can be performed in the same manner as in a case of full sampling even in a case of undersampling, the same correction effect can be maintained even in a case of being applied to the parallel imaging.

Based on the above outline, a specific embodiment will be described below.

### Embodiment 1

A feature of the N/2 ghost processing according to the present embodiment is to perform the one-shot pre-scan in which the blip-shaped phase-encoding gradient magnetic field is applied alternately in the EPI sequence to generate the N/2 ghost-free data having different polarities, to create the pseudo N/2 ghost data from the N/2 ghost-free data, to calculate the correction kernel based on the signals of the measurement point to be corrected and the signals of the measurement points on the even line and the odd line around the measurement point using the pseudo N/2 ghost data, and to correct the main scan data using the correction kernel with respect to the signals of the measurement point to be corrected and the measurement points on the even line and the odd line around the measurement point.

Hereinafter, contents of each processing will be described in detail. In the following description, FIGS. 1 to 4 will be appropriately referred to.

### Main scan: S1002

Before the description of the pre-scan, the main scan and the main scan data, which are the correction targets, will be described. Here, a case of performing the DWI will be described as an example, but the present invention is not limited to the DWI and can be applied to any imaging including the EPI sequence.

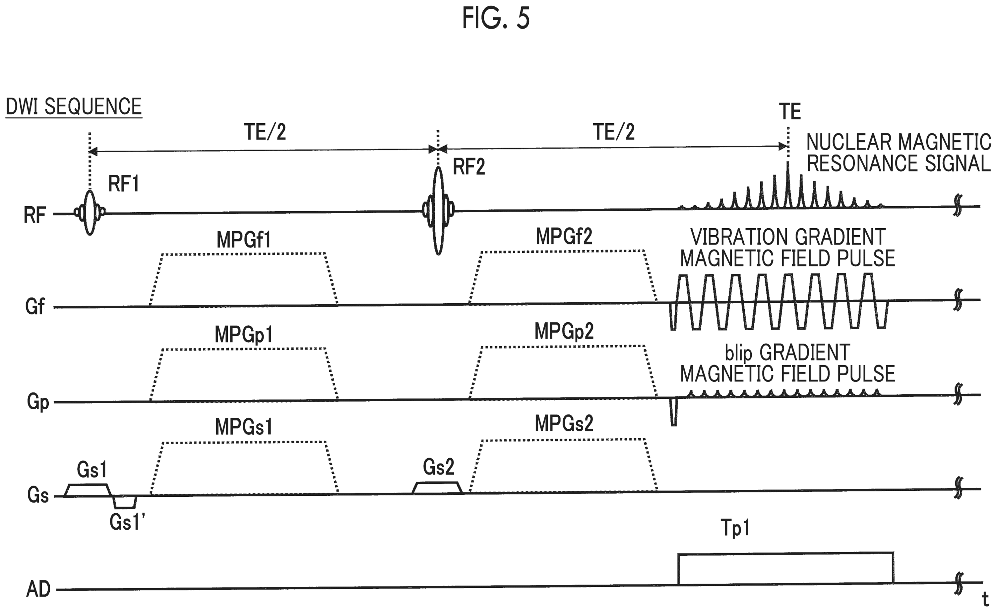

As shown in FIG. 5, in the DWI, an RF pulse RF1 for excitation and an RF pulse RF2 of 180 degrees are applied, and large-amplitude MPG pulses (MPGf1, MPGf2, MPGp1, MPGp2, MPGs1, MPGs2) are applied before and after the 180-degree RF pulse RF2. Next, the vibration readout gradient magnetic field and the blip-shaped phase-encoding gradient magnetic field are applied, and the echo generated each time the readout gradient magnetic field is inverted is sampled over substantially the entire application period of the gradient magnetic field. In the parallel imaging, the k-space data is undersampled at a predetermined ratio according to the acceleration rate. In FIG. 5, Gf, Gp, and Gs represent a frequency encoding direction (readout direction) gradient magnetic field, a phase encoding direction gradient magnetic field, and a slice direction gradient magnetic field, respectively, and AD represents a sampling time of the echo data.

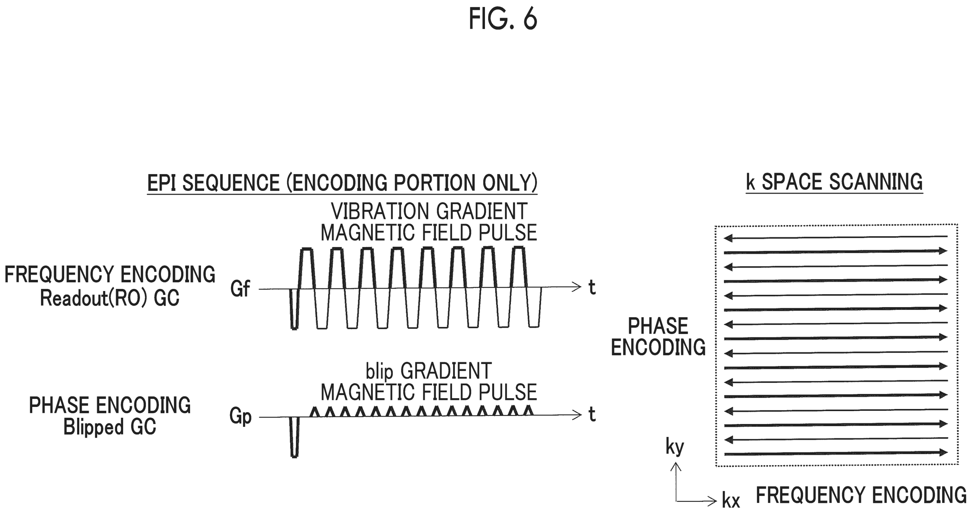

With this EPI sequence, as shown on the right side of FIG. 6, data of the entire k-space in which the number of lines corresponding to the number of echoes is arranged in the ky direction is collected in one shot (one excitation). The interval Δky of the lines corresponds to the application amount of the blip-shaped phase-encoding gradient magnetic field. The left side of FIG. 6 is a diagram showing an encoding portion of the EPI sequence of FIG. 5. As shown in FIG. 6, in a case where a case where the polarity of the readout gradient magnetic field is positive is indicated by a thick solid line and a case where the polarity of the readout gradient magnetic field is negative is indicated by a thin solid line in the k-space data, the data in the case of the positive polarity is on the odd line, and the data in the case of the negative polarity is on the even line. In this case, the deviation at the echo peak position between the odd line and the even line is the cause of the N/2 ghost.

In the present embodiment, the pre-scan is executed before the main scan, and the N/2 ghost is corrected using the correction kernel calculated based on the reference data collected in the pre-scan.

### Pre-scan: S1001

The pre-scan is a scan using the EPI sequence including the vibration readout gradient magnetic field and the blip-shaped phase-encoding gradient magnetic field as in the main scan, but in the main scan, the blip-shaped phase-encoding gradient magnetic field is applied each time the polarity of the readout gradient magnetic field is inverted, whereas in the pre-scan, the blip-shaped phase-encoding gradient magnetic field is applied alternately. As a result, the same phase encoding is applied to the pair of positive and negative data (odd echo and even echo). In a case where the main scan is the DWI in which the MPG is applied, the phase deviation between the positive polarity and the negative polarity does not change even in a case where the MPG is omitted in the pre-scan, and thus it is preferable to omit the MPG in order to increase the SNR.

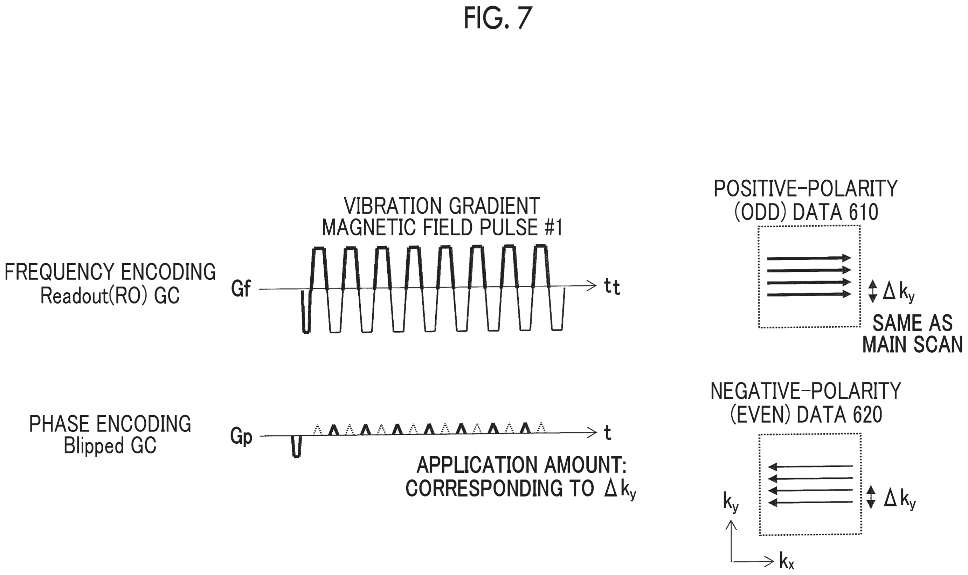

FIG. 7 shows a part (encoding portion) of the pulse sequence of the pre-scan and the k-space disposition of the echo signal collected by the sequence. As can be seen from the comparison with the main scan shown in FIG. 6, in the pre-scan, the blip-shaped gradient magnetic field (phase-encoding gradient magnetic field) is applied only in a case where the readout gradient magnetic field is the negative polarity (or only in a case where the readout gradient magnetic field is the positive polarity). The application amount of the blip-shaped phase-encoding gradient magnetic field (corresponding to Δky) is the same as that in the main scan. As shown on the right side of FIG. 7, data 600 collected by such a pre-scan is obtained as data (positive-polarity data 610) in a case where the readout gradient magnetic field is the positive polarity and data (negative-polarity data 620) in a case where the readout gradient magnetic field is the negative polarity with the same phase encoding, that is, on the same line. The interval Δky of the lines is the same as the interval between the lines in the main scan.

In addition, although not limited thereto, the FOV of the pre-scan is set such that the number of echoes in the pre-scan is the same as the number of echoes in the main scan. However, by setting the FOV of the pre-scan and the FOV of the main scan to be the same, the correction kernel with high accuracy can be calculated.

FIGS. 6 and 7 show a case where the main scan and the pre-scan are performed at an acceleration rate = 1, but it is also possible to perform the main scan and the pre-scan at a predetermined acceleration rate (> 1). In this case, although not limited thereto, the main scan and the pre-scan are executed at the same acceleration rate and with the same sampling pattern, so that the correction kernel with high accuracy, which will be described below, can be calculated.

### N/2 ghost correction: S1003

### Creation of pseudo N/2 ghost data: FIG. 4, S1101

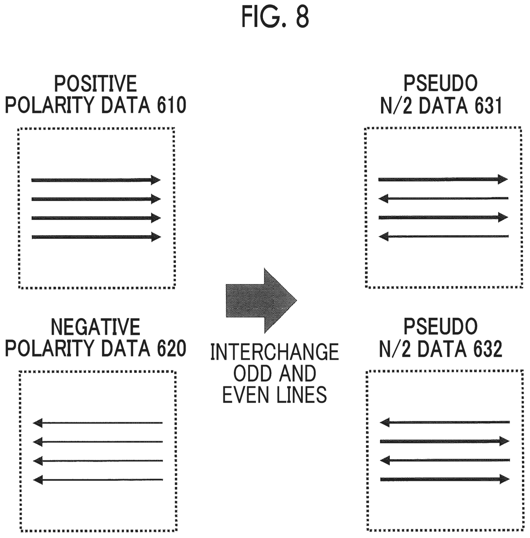

The processor 200 (pseudo N/2 ghost data generation unit 221) generates the pseudo N/2 ghost data (hereinafter, abbreviated as pseudo data) from the data obtained by the pre-scan. Therefore, as shown in FIG. 8, first, the reference data 600 is divided into data (positive-polarity data 610) consisting of the odd line and data (negative-polarity data 620) consisting of the even line, and the odd line and the even line of the positive-polarity data 610 and the negative-polarity data 620 are interchanged to generate the pseudo data in which the positive-polarity data and the negative-polarity data are alternately arranged for each of the positive-polarity data 610 and the negative-polarity data 620. Two pieces of pseudo data are generated, which are a combination of the odd line of the positive-polarity data and the even line of the negative-polarity data (pseudo data 631) and a combination of the odd line of the negative-polarity data and the even line of the positive-polarity data (pseudo data 632).

As described above, in the present embodiment, since the data for calculating the correction kernel can be created from the one-shot reference data, the extension of the imaging time can be suppressed, and the decrease in the correction accuracy due to the influence of the body motion can be prevented, as compared with a method of acquiring the reference data in two shots as described in W. Scott Hogel* and Jonathan R. Polimeni. Dual-Polarity GRAPPA for Simultaneous Reconstruction and Ghost Correction of Echo Planar Imaging Data. Magn Reson Med 2016;76:32-44.

### Calculation of correction kernel: S1102

The correction kernel is a matrix of weights to be multiplied by each of signals (hereinafter, referred to as source signals) used to convert a correction target signal (hereinafter, referred to as a target signal) into a corrected signal, and the corrected signal is obtained by performing a convolution operation on the source signal using the weight corresponding to the correction kernel.

In the present embodiment, the correction kernel calculation unit 222 calculates the correction kernel using the two pieces of pseudo data 631 and 632. Here, as an example, a case where the kernel size of the correction kernel is 3 × 3 will be described. That is, here, the correction kernel is calculated using the correction target signal, the signals on both sides of the correction target signal in the kx direction, and three data on the upper and lower lines (positive polarity lines) for the correction target signal in a case where the correction target signal is the negative polarity line, and a total of nine data for the three signals.

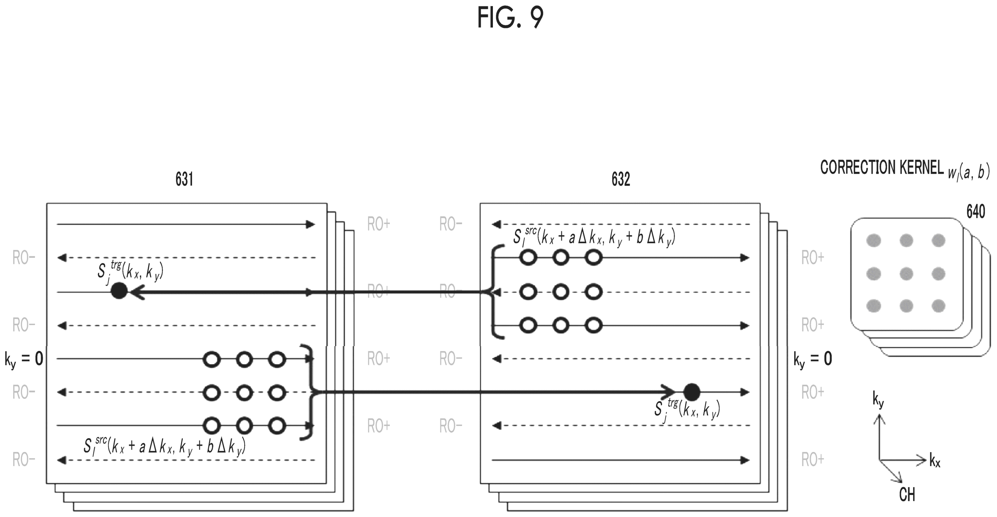

Hereinafter, the calculation of the correction kernel will be described with reference to FIG. 9. FIG. 9 shows a case where the correction kernel is calculated for each channel CH of the reception coil.

As shown in FIG. 9, the pseudo data 631 and 632 are k-space data in which the positive-polarity data (data having a rightward trajectory) indicated by a solid line and the negative-polarity data (data having a leftward trajectory) indicated by a dotted line are alternately arranged, and the lines corresponding to each other in the ky direction in the pseudo data 631 and the pseudo data 632 have opposite polarities. The N/2 correction of the present embodiment is performed by converting the negative-polarity signal (hereinafter, referred to as a source signal (Sₗ^{src})) to be corrected indicated by "O" and the positive-polarity signal around the negative-polarity signal (in this example, there are nine target signals) in FIG. 9 into the positive-polarity signal (hereinafter, referred to as a target signal (Sⱼ^{trg})) to be corrected indicated by "•", and the matrix of weights of the target signal used for the conversion is the correction kernel. Therefore, the calculation of the correction kernel is the calculation of the weight, and is performed using a least-squares method as shown in the following equation.

First, as described above, the odd line of the pseudo data 631 is set as the target signal (Sⱼ^{trg}), the point around the same coordinates of the pseudo data 632 is set as the source signal (Sₗ^{src}), the even line of the pseudo data 632 is set as the target signal (Sⱼ^{trg}), and the point around the same coordinates of the pseudo data 631 is set as the source signal (Sₗ^{src}). In a case where the kernel weight of each source signal is W₁, the target signal (Sⱼ^{trg}) can be represented by Equation (1). The weight W (matrix representation) is calculated by the least-squares method as shown in Equation (4). Here, the subscript H of Equation (4) represents a complex conjugate transpose of a matrix. Here, it is assumed that the reception coil is a multi-channel coil, and the correction kernel is calculated for each channel ch. ${S}_{j}^{trg} \left({k}_{x}, {k}_{y}\right) = {\sum }_{i = 1}^{{N}_{c}} {\sum }_{b = - {N}_{b}}^{{N}_{b}} {\sum }_{a = - {N}_{a}}^{{N}_{a}} {w}_{i} \left(a, b\right) {S}_{i}^{src} \left({k}_{x}+aΔ{k}_{x},{k}_{y}+bΔ{k}_{y}\right)$ Where, $\begin{matrix}{k}_{y} = \left\{\begin{matrix}2 {n}_{p} + 1 \\ 2 {n}_{p}\end{matrix}\right. & if pseudo data 631 \\ Representing Equation \left(1\right) & if pseudo data 632\end{matrix}$ ${\to }^{in matrix form :} {s}_{trg} = {S}_{src} w$ ${\to }^{Least Squares Method} w = {\left({S}_{src}^{H}{S}_{src}\right)}^{- 1} {S}_{src}^{H} {s}_{trg}$

The symbols in the equation are as follows.
***kₓ*:** Coordinate in the x-direction of k-space
***k_{y}*** : Coordinate in the y-direction of k-space
**Δ*kₓ:*** Pixel size (step size) in the x-direction of k-space
**Δ*k_{y}*** : Pixel size (step size) in the y-direction of k-space
${S}_{j}^{trg}$ : Target signal of the j-th channel
${S}_{i}^{src}$ : Source signal of the l-th charmel
***a*** Coordinate in the x-direction within the kernel
***b*:** Coordinate in the y-direction within the kernel
***w_{ℓ}*:** Kernel weights of the l-th channel
***Nₐ*:** Range of the kernel in the x-direction
***N_{b}:*** Range of the kernel in the y-direction
***N_{c}:*** Number of coil channels
***Nₚ*:** Number of phase encoding points
***n*:** Phase encoding step number (0-indexed)
Kernel size in x-direction : ***Kₓ* = 2N*ₐ* + 1**
Kernel size in y-direction : ***K_{y}* = 2*N_{b}* + 1**

As a result, one correction kernel is calculated for one set of the pseudo data 631 and 632. The correction kernel is calculated for the number of channels for the plurality of channels.

In FIG. 9, a case is shown in which the negative-polarity signal to be corrected is converted (corrected) into the positive-polarity signal using the negative-polarity signal to be corrected and the surrounding negative-polarity signals and the surrounding positive-polarity signals, but conversely, the positive-polarity signal may be converted into the negative-polarity signal. In this case, the positive-polarity signal to be corrected is converted into the negative-polarity signal using the positive-polarity signal to be corrected and the positive-polarity signal and the negative-polarity signal around the positive-polarity signal to be corrected.

In addition, in a case where the pre-scan and the main scan have the same acceleration rate and the same sampling pattern (thinning-out method of the lines), the correction kernel can be calculated in the same manner as in the data having the acceleration rate = 1, except that the interval between the lines is different, and the correction kernel can be used for the correction of the main scan in the same manner.

In the method of the related art, for example, the method of US11002815B and US10557907B, the kernel for estimating the positive-polarity signal is calculated using the positive-polarity signals around the negative-polarity signal to be corrected, and the positive-polarity signal is estimated by the substantially same method as the parallel imaging method (GRAPPA), so that the SNR is likely to decrease and the G-factor is likely to deteriorate. However, according to the present embodiment, the positive-polarity signal is estimated using not only the positive-polarity signal around the negative-polarity signal to be corrected but also the negative-polarity signal to be corrected itself, so that the correction accuracy can be improved, the SNR is not decreased, and the decrease in the accuracy in a case where the acceleration rate is increased by the parallel imaging method can be suppressed.

### Correction of main scan data: S1103

The main scan is a scan including the EPI sequence as in the pre-scan described above. Although not limited thereto, for example, the DWI sequence shown in FIG. 5 is used, and the main scan data as shown on the right side of FIG. 6 is obtained.

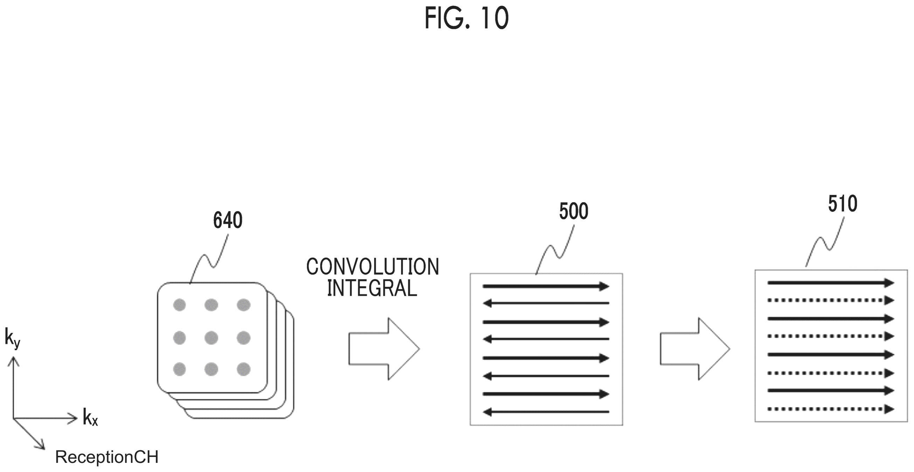

As shown in FIG. 10, the correction of the main scan data is performed by performing a convolution integral using the correction kernel 640 calculated from the reference data as shown in Equation (1) described above, using each signal constituting main scan data 500 as the target signal, to obtain corrected main scan data 510. Since the corrected main scan data 510 is converted into the main scan data in which all the signals are the positive-polarity data (or the negative-polarity data), the corrected main scan data 510 is data that does not include the N/2 ghost. In addition, since the convolution operation using the correction kernel is performed, the high-order component of the phase is also corrected, so that the N/2 ghost does not remain as in the 1D correction, and the correction accuracy is high.

### Image Reconstruction: S1004

The image reconstruction of the corrected main scan data can be performed by a known method such as reconstruction by high-speed FT, reconstruction by the parallel imaging method, and reconstruction using iterative calculation.

According to the present embodiment, since the data for calculating the correction kernel is created from the one-shot reference data, the extension of the imaging time can be suppressed as much as possible. In addition, since the correction kernel is created using the positive-polarity signal and the negative-polarity signal around the negative-polarity signal to be corrected and using the negative-polarity signal to be corrected itself, the number of points used for the correction can be increased as compared with a case where the negative-polarity signal to be corrected itself is not used, and the accuracy of the correction can be improved. Furthermore, according to the present embodiment, the correction with high accuracy can be performed regardless of the acceleration rate of the main scan data to be corrected, and the correction effect does not decrease even at a high acceleration rate.

### Modification Example of Embodiment 1

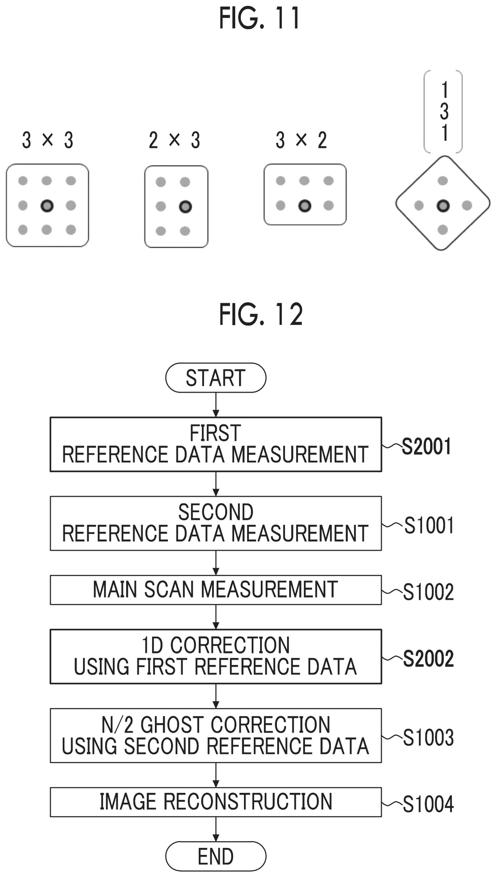

In Embodiment 1, the case where the correction kernel size is 3 × 3 has been described, but the kernel size is not limited to 3 × 3, and the correction kernel can be calculated using the correction target signal and one or more signals adjacent to the correction target signal. The kernel size may be 1 × 2 or 2 × 1 or more, and the size in the ky direction and the size in the kx direction may be the same or different from each other. Furthermore, the shape of the matrix is not limited to a square or a rectangle, and for example, as shown in FIG. 11, a rhombic correction kernel can also be used with the correction target signal at the center.

### Embodiment 2

In Embodiment 1, the correction kernel is calculated from the reference data obtained by the pre-scan, and the N/2 ghost of the main scan is corrected, but the 1D correction may be performed on the reference data and the main scan data before the correction using the correction kernel, and then the correction kernel may be calculated and the main scan data may be corrected using the correction kernel.

FIG. 12 shows a flow of processing of the present embodiment. In FIG. 12, the same processing as the processing shown in FIG. 1 is denoted by the same reference numerals, and duplicate description thereof will be omitted. As shown in FIG. 12, in the present embodiment, the pre-scan for the 1D correction is executed (S2001), and the 1D correction is performed using the data obtained by the pre-scan (S2002). In order to distinguish between the pre-scans, the pre-scan performed for the 1D correction is referred to as a first pre-scan, and the pre-scan performed for calculating the correction kernel is referred to as a second pre-scan. The 1D correction can be performed by the same method as the method described in Bruder H, Fischer H, Reinfelder HE, Schmitt F. Image reconstruction for echo planar imaging with nonequidistant k-space sampling. Magn Reson Med 1992;23:311-323. Hereinafter, the present embodiment will be briefly described.

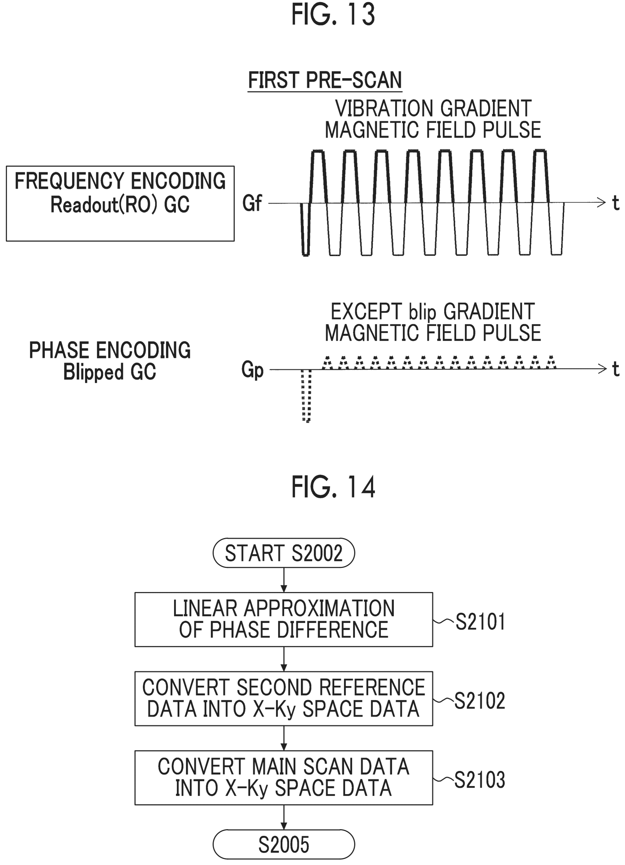

First, the measurement control unit 210 of the processor 200 executes each scan in the order of the first pre-scan, the second pre-scan, and the main scan, and collects first reference data, second reference data, and main scan data. The second pre-scan and the main scan are the same as in Embodiment 1, and for example, the entire k-space is scanned by the EPI sequence as shown in FIGS. 6 and 7. The first pre-scan is a scan performed to perform linear phase correction of the data obtained by the second pre-scan and the main scan, and is the same scan as the second pre-scan except that the blip-shaped phase-encoding gradient magnetic field is not applied, as shown in FIG. 13. Although not limited thereto, the imaging conditions such as the FOV are substantially the same for the second pre-scan and the main scan.

Next, the 1D linear phase correction unit 224 performs the 1D correction using the three pieces of data measured (S2002). In the 1D correction, as shown in FIG. 14, first, the data obtained by the first pre-scan is converted into x-ky space data, a phase difference between the odd line and the even line of the x-ky space data is calculated, and the phase difference is linearly approximated (S2101). Next, the linearly approximated phase difference is used to perform one-dimensional phase correction on each of the second reference data and the main scan data (S2102 and S2103). The one-dimensional phase correction is performed by converting the second reference data and the main scan data into x-ky space data, correcting the odd line data or the even line data with the linearly approximated phase difference, and performing processing of aligning one with the other. Here, in the 2D correction (correction using the correction kernel) to be performed subsequently, in a case where the positive-polarity data is the odd line data and the processing of converting the negative-polarity data into the positive-polarity data is performed, the processing of aligning with the odd line data is performed. In a case where the data serving as the reference data in the 2D correction is even, the 1D correction is also aligned with the data.

After the 1D correction is performed, the N/2 ghost correction unit 220 performs the N/2 ghost correction on the main scan data using the second reference data (S1003). The N/2 ghost correction is the same as in Embodiment 1, and the pseudo data is created using the second reference data (kx-ky data) after the 1D correction, the correction kernel is calculated using the pseudo data, and the main scan data after the 1D correction is corrected using the correction kernel (FIG. 4: S1101 to S1103). The correction kernel is arbitrary, such as a square matrix of 3 × 3 or the like, a rectangular matrix of 1 × 3, 2 × 3, 3 × 4, or the like, or a rhombic matrix, as in Embodiment 1, but in the present embodiment, since the 1D correction of the phase is performed, the correction kernel having a relatively small matrix size can also obtain high correction accuracy.

In the embodiment shown in FIG. 12, the case has been described in which the pre-scan (first pre-scan) for not applying the blip-shaped phase-encoding gradient magnetic field for the 1D correction is performed as the pre-scan, but the linear phase can be obtained from the data of the second pre-scan without performing the first pre-scan, and can be used for the 1D correction. In this case, the positive polarity line and the negative polarity line of the zero point in the phase encoding direction are converted into the x-ky space by one-dimensional FT, and the phase difference between the two lines is linearly approximated. The 1D correction of the main scan data by the linear approximation is the same as above.

In addition, the present embodiment can be applied in the same manner as in Embodiment 1 in a case where the acceleration rate > 1.

As described above, according to the present embodiment, by performing the linear phase correction on the reference data and the main scan data to be used for the correction kernel before the N/2 ghost correction, the correction accuracy can be maintained even in a case where the kernel size is small. The operation time can be shortened by reducing the kernel size.

### Effects of Embodiment

DWI imaging (b value = 0, number of channels = 6, number of slices = 8) was performed using a phantom, and the effects of the correction according to Embodiment 1 and Embodiment 2 were confirmed.

### Effects of Embodiment 1

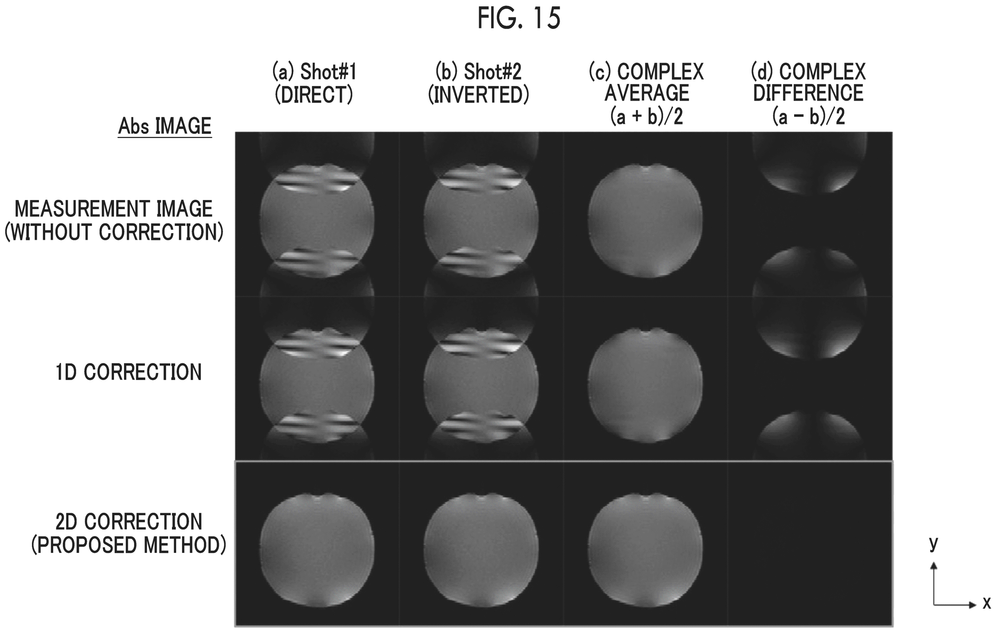

FIG. 15 is a diagram showing an absolute value image (number of channels = 6, slice = 1, phase encoding direction = AP direction, b value = 0) captured at an acceleration rate = 1, and shows (a) an image (direct image) acquired in a case where the first echo is acquired in a case where the polarity of the vibration readout gradient magnetic field is the positive polarity, (b) an image (inverted image) acquired in a case where the polarity of the vibration readout gradient magnetic field is inverted from (a) and the first echo is acquired in a case where the polarity of the vibration readout gradient magnetic field is the negative polarity, (c) a complex average of the direct image and the inverted image, and (d) a complex difference between the direct image and the inverted image, in order from the left. In addition, images before correction, after 1D correction, and after correction by the method of Embodiment 1 are shown in order from the top. From FIG. 15, it was confirmed that the positive and negative phase differences were eliminated by the method of Embodiment 1, and the N/2 ghost reduction effect was sufficiently obtained even in the data of one shot.

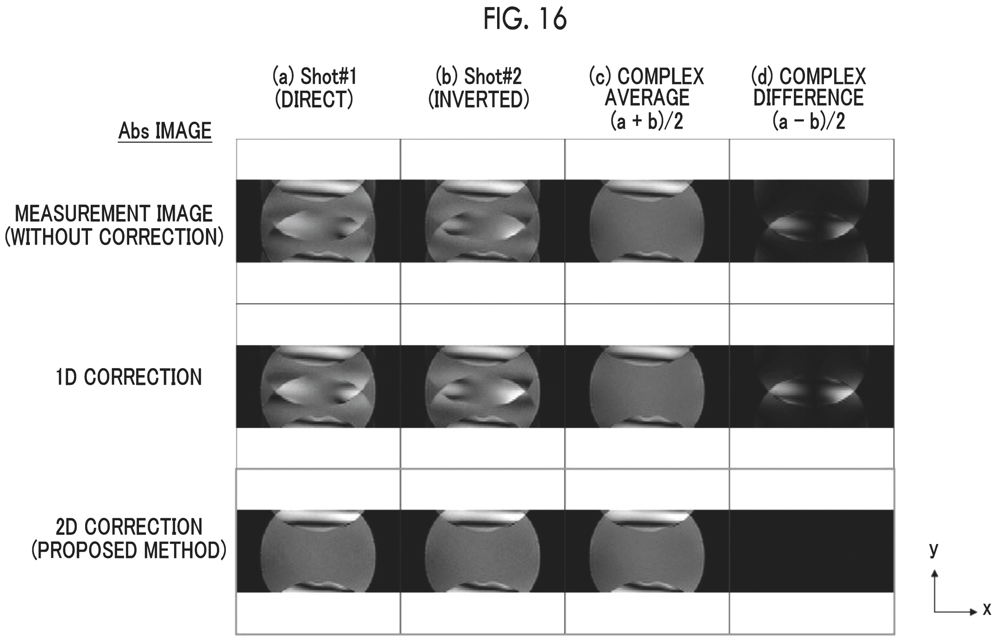

FIG. 16 is a diagram showing an image captured at an acceleration rate of 2 under the same conditions as the imaging of FIG. 15, and shows (a) a direct image, (b) an inverted image, (c) a complex average of the direct image and the inverted image, and (d) a complex difference between the direct image and the inverted image, in order from the left, for before correction, after 1D correction, and after correction of Embodiment 1, as in FIG. 15. From FIG. 16, it was confirmed that the correction effect was sufficient even in a case where the acceleration rate was doubled.

### Effects of Embodiment 2

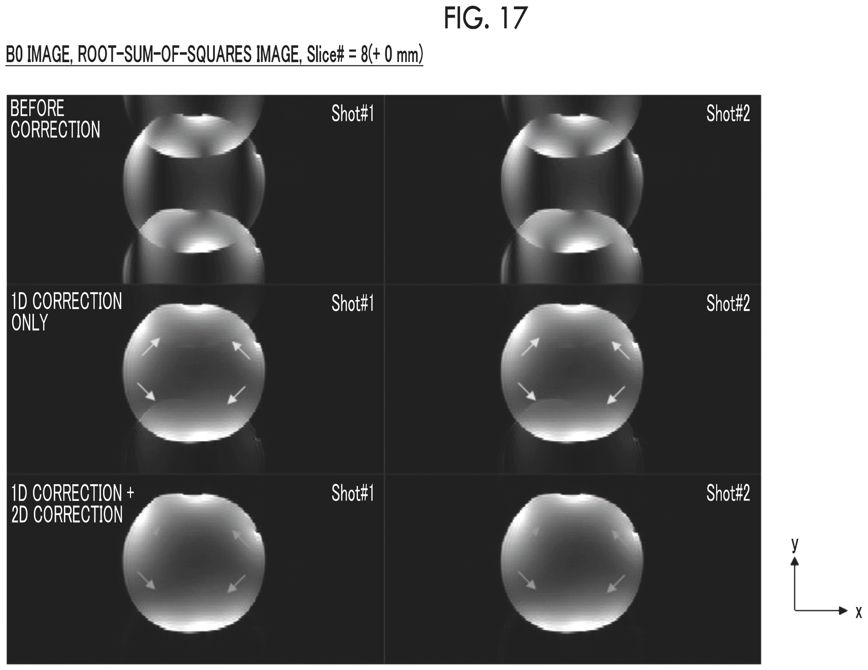

FIG. 17 shows an image obtained by taking the square root of the sum of squares of the images for each channel. The left side of FIG. 17 is the direct image, and the right side is the inverted image. In addition, FIG. 17 shows a result image before correction, after 1D correction, and after correction by the method of Embodiment 2, in order from the top. As shown in FIG. 17, the N/2 ghost appearing in the image reconstructed without correction is almost disappeared by the 1D correction, but slightly remains up and down. On the other hand, in a case where the correction of the present embodiment was performed, it was confirmed that the remaining ghost disappeared, and a high N/2 ghost correction effect was obtained.

Although the embodiments of the present invention have been described above, the present invention is not limited to the above-described embodiments and modification examples, and it is possible to add known configurations, correction processing, and the like as long as there is no technical contradiction. It is also possible to reconfigure the configuration of the processor or add another function, and a device or a method with these modifications is also included in the present invention.

### Explanation of References

10: MRI apparatus
100: imaging unit
200: processor
210: measurement control unit
220: N/2 ghost correction unit
221: pseudo N/2 ghost data generation unit
222: correction kernel calculation unit
223: main scan data correction unit
224: 1D linear phase correction unit
230: image reconstruction unit

## Claims

1. A magnetic resonance imaging apparatus comprising:
an imaging unit that measures a nuclear magnetic resonance signal generated from an examination target according to a predetermined pulse sequence; and
a processor that performs an operation including image reconstruction using the nuclear magnetic resonance signal and controls an operation of the imaging unit,
wherein the processor is configured to:
execute a pulse sequence based on an echo planar imaging method of applying, after one excitation RF pulse application, a readout gradient magnetic field, which has an application polarity that vibrates between positive and negative, and a blip-shaped phase-encoding gradient magnetic field, and measuring an echo signal and collecting k-space data each time the polarity of the applied readout gradient magnetic field is inverted, as a main scan;
execute a pre-scan sequence based on an echo planar imaging method of changing the application of the blip-shaped phase-encoding gradient magnetic field in the main scan such that the application is performed once per two inversions of the polarity of the readout gradient magnetic field, as a pre-scan;
divide reference k-space data collected in the pre-scan into first reference data consisting of a positive-polarity signal obtained in a case where the application polarity of the readout gradient magnetic field is positive and second reference data consisting of a negative-polarity signal obtained in a case where the application polarity of the readout gradient magnetic field is negative;
generate at least two pieces of pseudo N/2 ghost data in which the positive-polarity signal and the negative-polarity signal are alternately arranged, using the first reference data and the second reference data;
calculate a correction kernel for correcting N/2 ghost using the pseudo N/2 ghost data; and
correct, using the correction kernel, the main scan k-space data collected by executing the main scan, and perform image reconstruction using the corrected k-space data.

2. The magnetic resonance imaging apparatus according to claim 1,
wherein the processor is configured to:
calculate, as the correction kernel, a correction kernel for correcting a signal to be corrected using the signal to be corrected and at least one or more of the positive-polarity signals or the negative-polarity signals around the signal to be corrected; and
correct the main scan k-space data using the correction kernel and the signal to be corrected and at least one of the positive-polarity signals or the negative-polarity signals around the signal to be corrected in the main scan k-space data.

3. The magnetic resonance imaging apparatus according to claim 2,
wherein the processor is configured to calculate, as the correction kernel, a correction kernel for converting the signal to be corrected into a positive-polarity signal in a case where the signal to be corrected is a negative-polarity signal and converting the signal to be corrected into a negative-polarity signal in a case where the signal to be corrected is a positive-polarity signal, using the signal to be corrected and at least one or more positive-polarity signals or negative-polarity signals around the signal to be corrected.

4. The magnetic resonance imaging apparatus according to any one of the preceding claims,
wherein the processor is configured to control a FOV of the pre-scan k-space data to be the same as a FOV of the main scan k-space data, in the execution of the pre-scan sequence and the main scan sequence.

5. The magnetic resonance imaging apparatus according to any one of the preceding claims,
wherein a size of the correction kernel is N × M (N and M are any integers of 1 or more, excluding a case where N = M = 1).

6. The magnetic resonance imaging apparatus according to any one of the preceding claims,
wherein the processor is configured to:
linearly approximate a phase difference between a positive-polarity echo signal and negative-polarity echo signal;
correct a phase difference between the positive-polarity signal and the negative-polarity signal in the main scan k-space data using the linearly approximated phase difference; and
correct the main scan k-space data using the correction kernel after correcting the phase difference.

7. The magnetic resonance imaging apparatus according to any one of the preceding claims,
wherein the imaging unit includes one or more reception coils that receive the nuclear magnetic resonance signal, and collects k-space data for each reception coil, and
the processor is configured to calculate the correction kernel for each reception coil, and correct the main scan k-space data for each reception coil.

8. The magnetic resonance imaging apparatus according to any one of the preceding claims,
wherein the processor is configured to:
execute a main scan of collecting the k-space data at an acceleration rate of one or more;
control execution of the pre-scan at the same acceleration rate as the main scan; and
perform image reconstruction with interpolation of unmeasured data after correcting the main scan k-space data using the correction kernel.

9. The magnetic resonance imaging apparatus according to any one of the preceding claims,
wherein the processor is configured to, as the predetermined pulse sequence, control execution of a diffusion-weighted sequence including an application of an MPG pulse before the pulse sequence based on the echo planar imaging method.

10. A control method of a magnetic resonance imaging apparatus including an imaging unit that measures a nuclear magnetic resonance signal generated from an examination target according to a predetermined pulse sequence, and an operation unit that performs an operation including image reconstruction using the nuclear magnetic resonance signal, the control method comprising:
controlling the imaging unit to execute a main scan sequence based on an echo planar imaging method of applying, after one excitation RF pulse application, a readout gradient magnetic field, which has an application polarity that vibrates between positive and negative, and a blip-shaped phase-encoding gradient magnetic field, and measuring an echo signal and collecting k-space data each time the polarity of the applied readout gradient magnetic field is inverted, and a pre-scan sequence based on an echo planar imaging method of changing the application of the blip-shaped phase-encoding gradient magnetic field in the main scan such that the application is performed once per two inversions of the polarity of the readout gradient magnetic field;
controlling the operation unit to divide reference k-space data collected in a pre-scan into first reference data consisting of a first echo signal obtained in a case where the application polarity of the readout gradient magnetic field is positive and second reference data consisting of a second echo signal obtained in a case where the application polarity of the readout gradient magnetic field is negative;
generating at least two pieces of pseudo N/2 ghost data in which the first echo signal and the second echo signal are alternately arranged, using the first reference data and the second reference data;
calculating a correction kernel for correcting N/2 artifact included in the pseudo N/2 ghost data using the pseudo N/2 ghost data; and
correcting, using the correction kernel, the main scan k-space data collected by executing the main scan, and performing image reconstruction using the corrected k-space data.
